Europäisches Patentamt

European Patent Office

Office européen des brevets

(11) Publication number: **0 110 719**
**B1**

# (12) EUROPEAN PATENT SPECIFICATION

(45) Date of publication of patent specification: **22.04.87**

(51) Int. Cl.⁴: **H 03 B 5/36**

(21) Application number: **83307307.5**

(22) Date of filing: **30.11.83**

(54) **Oscillating circuit.**

(30) Priority: **30.11.82 JP 209875/82**

(43) Date of publication of application:
**13.06.84 Bulletin 84/24**

(45) Publication of the grant of the patent:
**22.04.87 Bulletin 87/17**

(84) Designated Contracting States:
**DE FR GB NL**

(56) References cited:
**DD-A- 107 182**
**DE-B-1 302 946**
**DE-C-1 948 582**
**FR-A-2 222 793**
**FR-A-2 510 843**
**US-A-3 134 947**
**US-A-4 358 742**

**Patent Abstracts of Japan vol. 4, no. 48 page
82E6 & JP-A-55-18183**

(73) Proprietor: **SONY CORPORATION**
**7-35 Kitashinagawa 6-Chome Shinagawa-ku
Tokyo 141 (JP)**

(72) Inventor: **Ishikawa, Nobuyuki**
**1298-14, Shimoogino**
**Atsugi-shi Kanagawa-ken (JP)**

(74) Representative: **Ayers, Martyn Lewis Stanley
et al
J.A. KEMP & CO. 14 South Square Gray's Inn
London, WC1R 5EU (GB)**

Courier Press, Leamington Spa, England.

## Description

This invention generally relates to an oscillating circuit and more particularly is directed to an oscillating circuit suitable for being used in a frequency converter for converting the center frequency of a frequency modulated signal.

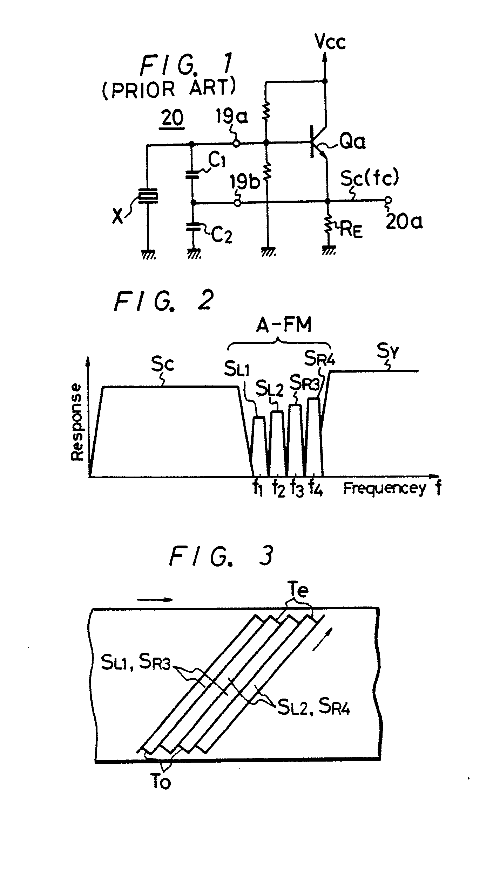

As an oscillator for a single frequency signal used in, for example, a frequency converter circuit, there is often used a Colpitts oscillator which employs a quartz oscillator as shown in Figure 1.

In Figure 1, reference letter Qa represents an amplifying transistor $C_1$, and $C_2$ capacitors for determining feedback capacitance and X a quartz vibrator or crystal resonator.

When the single signal used in the above signal converter circuit contains harmonics higher than the fundamental frequency, these harmonics can result in spurious signals. Therefore, it is desirable that the above single frequency signal has as low a harmonic content as possible.

However, since a Colpitts oscillator such as shown in Figure 1 at 20 contains a signal component of high order mode, it is difficult to produce a desired single frequency signal component. Also, when the oscillating or resonance frequency $f_c$ is relatively low, the capacities required of the capacitors $C_1$ and $C_2$ become relatively large. As a result, when the Colpitts oscillator 20 is formed as an IC (integrated circuit), it is necessary for the capacitors $C_1$ and $C_2$ to be connected thereto externally. Therefore, in that case, at least two external terminals 19a and 19b are required.

Further, in order to reduce as much as possible the distortion of the single signal Sc which is the oscillating output, it is necessary to adjust the feedback capacities of the capacitors $C_1$ and $C_2$ with accuracy. This adjustment is quite troublesome. Furthermore, in order to obtain a constant feedback capacity, when a resistor $R_E$ connected to the emitter of the transistor Qa is controlled in response to the output of the single signal Sc obtained at an output terminal 20a, if this circuit is formed as the IC, the resistor $R_E$ can not be controlled without difficulty.

Therefore, with the conventional circuitry as shown in Figure 1, it is impossible to easily obtain an oscillating output having low distortion.

An example of a prior art oscillating circuit is shown in DE—B—1 302 946 (Siemens AG) which corresponds to the pre-characterising portion of claim 1. The circuit of DE—B—1 302 946 comprises a first stage amplifier having an input and an output, a second stage terminal having an input connected via a crystal resonator, having a resonance frequency determined by a mechanical property of a crystal, to the output terminal of the first stage amplifier, and a feedback circuit connected between said second stage amplifier and the input terminal of said first stage amplifier and including a series circuit of a capacitor and a resistor, and a gain control circuit for controlling the total gain of the circuit, including a detector for detecting a signal from the second stage amplifier and a comparator for comparing the detected signal to a reference signal.

According to one aspect of the present invention, there is provided an oscillating circuit comprising:

a first stage amplifier having an input terminal and an output terminal;

a second stage amplifier having an input terminal connected to said output terminal of said first stage amplifier and an output terminal;

a feedback circuit connected between the output terminal of said second stage amplifier and the input terminal of said first stage amplifier and including a series circuit of a capacitor and a resistor;

a crystal resonator having a resonance frequency determined by a mechanical property of a crystal; and

means for controlling the total gain of the circuit,

characterised in that said first stage amplifier includes a common emitter transistor and the crystal resonator is connected to the emitter of said common emitter transistor, and the means for determining the total gain of the circuit is connected to said second stage amplifier for controlling the gain thereof and is so connected that the oscillating condition is satisfied at a frequency near said resonance frequency of said crystal resonator.

The above and other features and advantages of the present invention will become apparent from the following description, given by way of non-limitative example, taken in conjunction with the accompanying drawings through which the like references designate the same elements and parts. In the drawings:—

Figure 1 is a connection diagram showing an example of the conventional oscillator;

Figure 2 is a frequency spectrum diagram of a recording and reproducing system used to explain the present invention;

Figure 3 is a diagram showing a track pattern thereof;

Figure 4 is a systematic block diagram showing an example of a signal converting circuit in which an oscillator is used;

Figure 5 is a connection diagram showing an embodiment of an oscillating circuit according to the present invention;

Figures 6A and 6B are respectively graphs used to explain the operation of the oscillating circuit shown in Figure 5; and

Figure 7 is a connection diagram showing a practical example of the oscillating circuit shown in Figure 5.

Prior to describing the present invention, a technical field to which the present invention is suitable to be applied will be described.

In a VTR (video tape recorder) of, for example, the helical scan type, the magnetic tape consumption amount per unit time can greatly be reduced by employing high density recording. On the other hand, as the tape consumption amount is reduced, the necessary running speed of the magnetic tape becomes as very slow as approximately 1.33 cm/sec. As a result, since the relative speed between the stationary or fixed head used for recording the audio signal onto the tape and the magnetic tape becomes slow, the quality of the recorded audio signal is inevitably lowered and hence high-fidelity sound can not be enjoyed.

Therefore, it is proposed to employ a recording and/or reproducing system in which the audio signal is frequency modulated (FM-modulated), recorded together with the video signal by the rotary magnetic head and then reproduced to thereby improve the tone quality.

When this new recording and/or reproducing system is applied to a low frequency band conversion FM (frequency modulation) recording system (M system), as shown in Figure 2, an FM-modulated audio signal A—FM is frequency-multiplexed between the frequency bands of a low-frequency-band-converted carrier chrominance signal Sc and a frequency-modulated luminance signal $S_Y$.

In this example, left and right audio signals $S_L$ and $S_R$ are separated from each other and FM-modulated respectively, while in order to reduce zero beat noise caused by crosstalk components between adjacent channels, the carrier frequencies of the FM audio signals to be recorded in the adjoining channels are selected so as not to be coincident with each other.

For example, in the left audio signal $S_L$, the carrier frequencies $f_1$ and $f_2$ ($f_2=f_1+f_c$ where $f_c$ represents the frequency of, for example, 150 kHz) are FM-modulated, while in the right audio signal $S_R$, the carrier frequencies $f_3$ and $f_4$ ($f_3=f_2+f_c$ and $f_4=f_3+f_c$) are FM-modulated. Then, as shown in Figure 3, on a certain track To are recorded left and right FM audio signals $S_{L1}$ and $S_{R3}$ having the carrier frequencies $f_1$ and $f_3$, while on a succeeding track Te are recorded left and right FM audio signals $S_{L2}$ and $S_{R4}$ having the carrier frequencies $f_2$ and $f_4$.

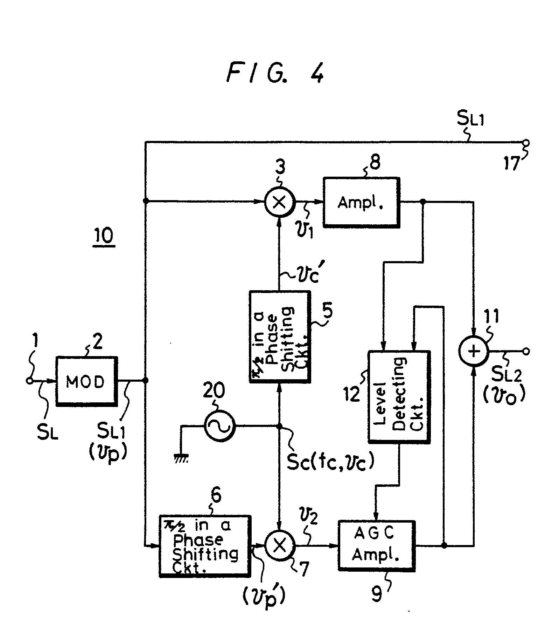

Figure 4 shows an example of the signal converting circuit 10 which produces the FM audio signals $S_{L1}$ to $S_{R4}$ to which the present invention is applicable. In Figure 4, the FM audio signals $S_{L1}$ to $S_{R4}$ are formed by forming the carrier frequency $f_2$ from the carrier frequency $f_1$ (or forming the carrier frequency $f_4$ from the carrier frequency $f_3$) according to the heterodyne system. Figure 4 shows a practical example in which the FM audio signals $S_{L1}$ and $S_{L2}$ are formed.

In Figure 4, the left audio signal $S_{L1}$ supplied to a terminal 1 is FM-modulated by an FM modulator 2 to be the FM audio signal $S_{L1}$ having $f_1$ as its the carrier frequency, which is then supplied to a first mixer (in this example, a balanced modulator) 3.

Reference numeral 20 designates an oscillator or oscillating circuit which oscillates at a frequency $f_c$. The single frequency signal $S_c$ as the oscillating output from the oscillator 20 is shifted in phase by π/2 in a phase shifting circuit 5 and then supplied to the first mixer 3.

The FM audio signal $S_{L1}$ is further shifted in phase by π/2 in a phase shifting circuit 6 and then supplied to a second mixer 7 to which the single signal Sc is supplied as it is. The output from the first mixer 3 is supplied through an amplifier 8 to a composer or adder 11 and the output from the second mixer 7 is supplied through an AGC (automatic gain control) amplifier 9 to the composer 11, respectively. Reference numeral 12 designates a level detecting circuit which generates an AGC voltage. In this example, the AGC amplifier 9 is controlled by the level detecting circuit 12 in such a manner that the level of the output from the second mixer 7 is made coincident with that of the output from the first mixer 3.

The operation of the signal converting circuit 10 will be described. In this case, for sake of convenience of description, the FM audio signal $S_{L1}$ upon non-modulation will be processed. It be assumed that the signal voltages at that time are respectively taken as indicated in Figure 4. When

$$vp=A \cos \omega_1 t \qquad (1)$$

A : amplitude
$\omega_1=2\pi f_1$
$f_1=$carrier frequency

$$vc=A' \cos \omega_c t \qquad (2)$$

A' : amplitude
$\omega_c=2\pi f_c$
$f_c$ : single frequency

thus

$$vp'=A \cos (\omega_1 t+\pi/2)=A \sin \omega_1 t \qquad (3)$$

$$vc'=A \cos (\omega_c t+\pi/2)=A' \sin \omega_c t \qquad (4)$$

$$\begin{aligned} \therefore v_1 &=vp \ vc' \\ &=K_1 \cos \omega_1 t \cdot \sin \omega_c t \quad (K_1=A \cdot A') \\ &=K_1 \frac{}{2} \{\sin (\omega_1+\omega_c) \ t-\sin (\omega_1-\omega_c) \ t\} \quad (5) \end{aligned}$$

and also

$$\begin{aligned} v_2 &=vp' \cdot vc \\ &=K_2 \sin \omega_1 t \cdot \cos \omega_c t \quad (K_2=A \cdot A') \\ &=K_2 \frac{}{2} \{\sin (\omega_1+\omega_c) \ t+\sin (\omega_1-\omega_c) \ t\} \end{aligned}$$

If

$$K_1=K_2,$$

thus

$$\begin{aligned} v_0 &=v_1+v_2 \\ &=K \sin (\omega_1+\omega_c) \ t \qquad (7) \end{aligned}$$

$$K=K_1=K_2$$

When the mixing of the frequencies is carried out as described above, as shown by the equations (5) and (6), there are generated first and second converted outputs (upper and lower side band components) which are respectively frequency-converted to higher and lower sides as $f_1+f_c$ and $f_1-f_c$ with the carrier frequency $f_1$ as the center. If the phases of the signals applied to the first and second mixers 3 and 7 are properly determined and the AGC amplifier 9 is controlled in such a manner that the levels $K_1$ and $K_2$ of the outputs $v_1$ and $v_2$ from the first and second mixers 3 and 7 may become equal to each other, the converted output which is frequency-converted to the side higher by $f_c$ than the carrier frequency $f_1$, namely, the FM audio signal $S_{L2}$ can be obtained just by adding the first mixer output $v_1$ and the second mixer output $v_2$ to each other.

The above relation can be established for a case in which the FM audio signal $S_{R3}$ FM-modulated by the audio signal $S_R$ is frequency-converted to obtain a converted output having a frequency higher by $f_c$ than the carrier frequency $f_3$, namely, the FM audio signal $SR_4$.

When the FM audio signal $S_{R4}$ is frequency-converted to provide a converted output having a frequency lower by $f_c$ than the carrier frequency $f_4$, namely, the FM audio signal $S_{R3}$, it may be sufficient that a subtracter is used in place of the adder 11 to subtract the first mixer output $v_1$ from the second mixer output $v_2$.

Also in the reproducing system, the same signal converting circuit is employed.

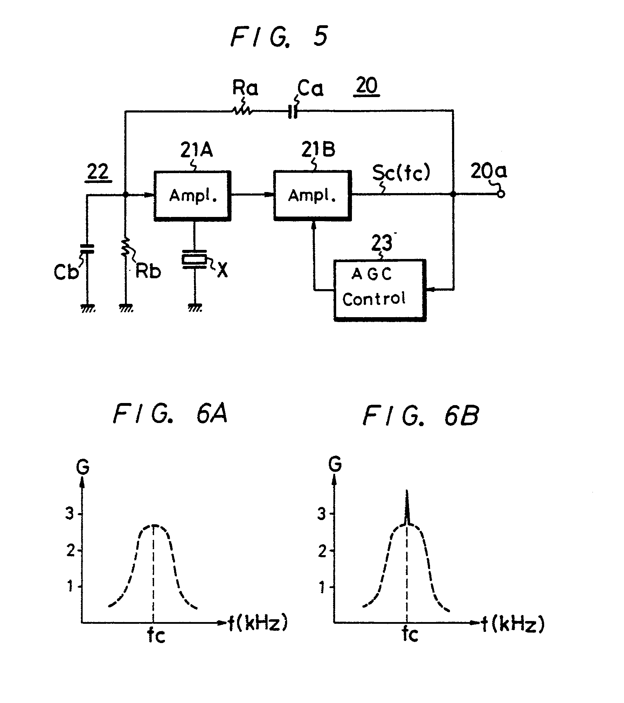

Now, an embodiment of the oscillating circuit according to the present invention which is usable as the oscillator 20 in the signal converting circuit 10 shown in Figure 4 will hereinafter be described in detail with reference to Figure 5.

Figure 5 is a systematic block diagram showing an embodiment of the oscillating circuit 20 according to the present invention. The oscillating circuit 20 includes a first stage and a second or last stage amplifier 21B. The single signal Sc which is an output signal obtained at an output terminal 20a of the circuit 20 is fed back to the first stage amplifier 21A through a feedback circuit 22 which consists of a series connection of a capacitor Ca and a resistor Ra and a parallel connection of a capacitor Cb and a resistor Rb.

The resonance frequency of this feedback circuit 22 is selected to be the same as or near the oscillating or resonance frequency $f_c$ of a crystal resonator X.

In the present invention, the crystal resonator X is connected to the first stage amplifier 21A so as to make the total gain of the whole of the system exceed that required for oscillation. Therefore, the total gain provided when the crystal resonator X is not connected to the first stage amplifier 21A cannot satisfy the oscillating condition.

Reference numeral 23 designates an AGC control circuit and by the output therefrom, the gain of the last stage amplifier 21B is controlled so that the signal Sc appearing at the output terminal 20a is always constant.

Unless the crystal resonator X is not connected to the amplifier 21A, the oscillating circuit 20 becomes the same as a Wien bridge type oscillator in construction. The total gain when the crystal resonator X is not connected to the amplifier 21A (the total gain after the AGC control is carried out) is selected to be slightly smaller than the critical gain at which oscillation occurs. An example of the gain characteristic under the condition that the critical gain is "3" and the crystal resonator X is not provided is shown by the curve in the graph of Figure 6A.

On the contrary, when the crystal resonator X having a resonance frequency $f_c$ is connected to the amplifier 21A, the oscillating circuit 20 is selected such that its total gain becomes larger than the critical gain thereof. As a result, only when the crystal resonator X is connected to the amplifier 21A, the oscillating circuit 20 carries out its oscillating operation. The gain characteristic at that time is shown in the graph of Figure 6B.

As is well known, a CR type oscillator formed of a capacitor and a resistor generally has poor stability, while an oscillator employing a crystal resonator has significantly higher stability. In the crystal resonator, however, frequency components of high order exist in addition to the fundamental or resonance frequency $f_c$. There is then the problem that the oscillating output is not a pure sine wave.

However, by providing the feedback circuit 22 as in the present invention, the high order frequency components are suppressed by the feedback circuit 22 and also the oscillating circuit 20 is made to oscillate only at the fundamental frequency $f_c$ so that an oscillating output can be generated whose distortion components are acceptably low.

In this case, in order to reduce the high-order frequency component more, it is better that the oscillating circuit 20 is operated in the critical oscillating state. However, if the oscillating circuit 20 is operated in the critical state, there is the possibility that the oscillating operation may become extremely unstable.

Therefore, the AGC system is provided to control the gain of the last stage amplifier 21B, namely to perform the AGC operation in such a manner that the total gain of the oscillating circuit 20 is always a little larger than the oscillating critical gain. Thus, the oscillating circuit 20 oscillates in substantially the fundamental mode so that the frequency components of high order can better be suppressed as compared with the prior art. Since the range of the AGC has to equal the fluctuation range of the total gain when the crystal resonator X is connected to the first stage amplifier 21A, such AGC range is quite narrow and hence it becomes easy to apply the AGC.

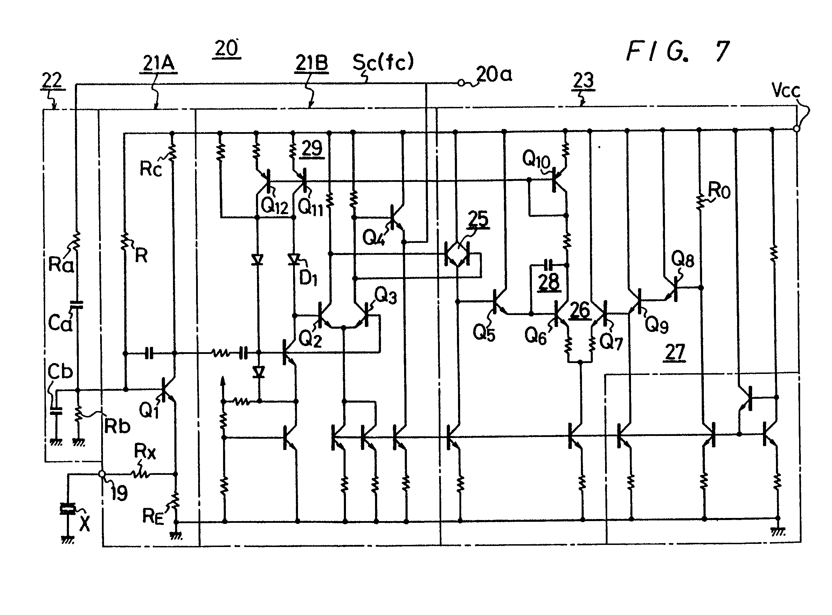

Figure 7 is a connection diagram showing a practical example of the above oscillating circuit 20. In Figure 7, the amplifier 21A includes an amplifying transistor $Q_1$ and the gain of the amplifier 21A is substantially determined by the resistance ratio between a collector resistor Rc and an emitter resistor $R_E$ of the transistor $Q_1$. As shown in Figure 7, the crystal resonator X is connected through a resistor Rx to the emitter of the transistor $Q_1$.

The last stage amplifier 21B, namely, the AGC amplifier 21B comprises a differential amplifier which consists of a pair of transistors $Q_2$ and $Q_3$ as shown in the figure. The output terminal 20a is led out from the collector of the transistor $Q_3$ through an emitter-follower transistor $Q_4$. The output from the differential amplifier is fully rectified by a full-wave rectifying circuit 25 formed of a pair of transistors and located in an AGC control voltage generating circuit 23 and then supplied via an emitter follower transistor $Q_5$ to a comparing circuit 26.

The comparing circuit 26 is formed of a differential amplifier which consists of a pair of transistors $Q_6$ and $Q_7$. A reference voltage is applied to one transistor $Q_7$. To this end, a power source voltage dropped through a resistor Ro is further dropped by a pair of transistors $Q_8$ and $Q_9$, which then is supplied to the transistor $Q_7$ as the reference voltage. Reference numeral 27 designates a current source.

The other transistor $Q_6$ of the comparing circuit 26 is provided with a mirror integrating circuit 28 the output of which is supplied via a current mirror circuit 29 formed of transistors $Q_{10}$ to $Q_{12}$ and a voltage converting diode $D_1$ to the transistor $Q_2$ forming the differential amplifier.

The gain G at the first stage amplifier 21A is calculated by

$$G = \frac{R_c}{R_E}$$

This calculated gain is the gain in the case where the crystal resonator X is not connected to the amplifier 21A.

On the other hand, when the crystal resonator X is connected to the amplifier 21A, the gain Gx of this case is calculated as

$$Gx = \frac{Rc}{R_E /\!/ R_x}$$

Where Rc, $R_E$ and Rx are the values of the resistors Rc, $R_E$ and Rx.

Since Gx>G the resistance values Rc, $R_E$ and Rx are selected to satisfy the condition Gx≧3.

Using the circuitry as described above, when this circuitry is formed as the IC, only one terminal pin 19 (see Figure 7) is necessary as an external terminal pin for the connection of the crystal resonator X, so that the number of terminal pins can be reduced as compared with the case shown in Figure 1.

While in the above description the oscillating circuit according to the present invention is used as the oscillator of the signal converting circuit used in a magnetic recording and reproducing apparatus, the oscillating circuit of the present invention can, of course, be applied to an oscillator in other type magnetic recording and reproducing apparatus and to other electronic devices to the same effect.

While in the embodiment shown in Figure 5 the G3 is exemplified as the oscillating critical gain of the oscillator, other values are also possible. Furthermore, when the crystal resonator X is not connected to the amplifier 21A, the values of the capacitors Ca and Cb and the resistors Ra and Rb are selected to be such that the oscillating frequency of the oscillating circuit 20 becomes equal to or near the fundamental frequency $f_c$. Even if these values are a little scattered, the oscillating circuit 20 does not oscillate at a frequency other than the resonance frequency $f_c$ determined by the crystal resonator X. Therefore, even if the values are changed somewhat, it is not necessary to correct the constants.

Using the circuitry described above it is possible to provide an oscillating circuit which is relatively simple in arrangement, excellent in stability, low in distortion and suitable for being formed as the IC. Thus, the oscillating circuit is particularly suitable for being used as the oscillating circuit in signal converting circuits and the like which are required to produce a highly stable and low distortion oscillating output.

**Claims**

1. An oscillating circuit comprising:
a first stage amplifier (21A) having an input terminal and an output terminal;
a second stage amplifier (21b) having an input terminal connected to said output terminal of said first stage amplifier (21A) and an output terminal;
a feedback circuit (22) connected between the output terminal of said second stage amplifier and the input terminal of said first stage amplifier and including a series circuit of a capacitor (Ca) and a resistor (Ra);
a crystal resonator (X) having a resonance frequency determined by a mechanical property of a crystal; and
means (23) for controlling the total gain of the circuit,
characterised in that said first stage amplifier (21A) includes a common emitter transistor (Q1) and the crystal resonator (X) is connected to the emitter of said common emitter transistor (Q1), and the means (23) for determining the total gain of the circuit is connected to said second stage amplifier (21B) for controlling the gain thereof and is so connected that the oscillating condition is satisfied at a frequency near said resonance frequency of said crystal resonator (X).

2. Oscillating circuit according to claim 1, wherein said feedback circuit (22) further includes a parallel circuit of a capacitor (Cb) and a resistor (Rb) connected between the input terminal of said first stage amplifier (21A) and ground.

3. Oscillating circuit according to claim 1 or 2 wherein said total gain determining means (23) includes a gain control circuit (23) detecting an output signal at the output terminal of said second stage amplifier (21B) for controlling the gain of said second stage amplifier.

4. Oscillating circuit according to claim 3, wherein said gain control circuit includes a detector (25) for detecting the output signal at the output terminal of said second stage amplifier and a comparator (26) for comparing the output of said detector (25) and a reference signal.

## Patentansprüche

1. Oszillatorschaltungsanordnung mit
einer ersten Verstärkerstufe (21A), die einen Eingangsanschluß und einen Ausgangsanschluß hat,
einer zweiten Verstärkerstufe (21B), die einen Eingangsanschluß, der mit dem Ausgangsanschluß der ersten Verstärkerstufe (21A) verbunden ist, und einen Ausgangsanschluß hat,
einer Ruckkopplungsschaltung (22), die zwischen den Ausgangsanschluß der zweiten Verstärkerstufe und den Eingangsanschluß der ersten Verstärkerstufe geschaltet ist und eine Reihenschaltung eines Kondensators (Ca) mit einem Widerstand (Ra) enthält,
einem Quarzschwinger (X), der eine Resonanzfrequenz hat, die durch die mechanischen Eigenschaften des Quarzes bestimmt ist, und
einem Mittel (23) zum Regeln des Gesamtverstärkungsfaktors der Schaltungsanordnung,
dadurch gekennzeichnet,
daß die erste Vertärkerstufe (21A) einen Transistor in Emitterschaltung (Q1) enthält,
daß der Quarzschwinger (X) mit dem Emitter des Transistors in Emitterschaltung (Q1) verbunden ist und
daß das Mittel (23) zum Bestimmen des Gesamtverstärkungsfaktors der Schaltungsanordnung mit der zweiten Verstärkerstufe (21B) zum Regeln des Verstärkungsfaktors derselben verbunden ist und derart geschaltet ist, daß die Schwingungsbedingung bei einer Frequenz nahe der Resonanzfrequenz des Quarzschwingers (X) erfüllt ist.

2. Oszillatorschaltungsanordnung nach Anspruch 1, bei der die Rückkopplungsschaltung (22) desweiteren eine Parallelschaltung eines Kondensators (Cb) mit einem Widerstand (Rb) enthält, die zwischen den Eingangsanschluß der ersten Verstärkerstufe (21A) und Erde geschaltet ist.

3. Oszillatorschaltungsanordnung nach Anspruch 1, bei der das Mittel (23) zum Bestimmen des Gesamtverstärkungsfaktors eine Verstärkungsfaktorregelschaltung (23) ist, die ein Ausgangssignal an dem Ausgangsanschluß der zweiten Verstärkerstufe (21B) zum Regeln des Verstärkungsfaktors der zweiten Verstärkerstufe erfaßt.

4. Oszillatorschaltungsanordnung nach Anspruch 3, bei der die Verstärkungsfaktorregelschaltung einen Detektor (25) zum Erfassen des Ausgangssignals an dem Ausgangsanschluß der zweiten Verstärkerstufe und einen Komparator (26) zum Vergleichen des Ausgangssignals des Detektors (25) mit einem Referenzsignal enthält.

## Revendications

1. Circuit oscillant comprenant:
un premier étage amplificateur (21A) possédant une borne d'entrée et une borne de sortie;
un deuxième étage amplificateur (21B) possédant une borne d'entrée connectée à ladite borne de sortie dudit premier étage amplificateur (21A) et une borne de sortie;
un circuit de réaction (22) connecté entre la borne de sortie dudit deuxième étage amplificateur et la borne d'entrée dudit premier étage amplificateur et comportant un circuit série fait d'un condensateur (Ca) et d'une résistance (Ra);
un résonateur à cristal (X) possédant une fréquence de résonance déterminée par les propriétés mécaniques d'un cristal; et
un moyen (23) permettant de commander le gain total du circuit,
caractérisé en ce que le premier étage amplificateur (21A) comporte un transistor à émetteur commun $(Q_1)$ et le résonateur à cristal (X) est connecté à l'émetteur dudit transistor à émetteur commun $(Q_1)$, et en ce que le moyen (23) permettant de déterminer le gain total du circuit est connecté audit deuxième étage amplificateur (21B) afin de commander son gain et est connecté de façon que la condition d'oscillation soit satisfaite pour une fréquence voisine de ladite fréquence de résonance dudit résonateur à cristal (X).

2. Circuit oscillant selon la revendication 1, où ledit circuit de réaction (22) comporte en outre un circuit parallèle fait d'un condensateur (Cb) et d'une résistance (Rb) connectés entre la borne d'entrée dudit premier étage amplificateur (21A) et la terre.

3. Circuit oscillant selon la revendication 1 ou 2, où ledit moyen (23) déterminant le gain total comporte un circuit (23) de commande de gain qui détecte un signal de sortie sur la borne de sortie dudit deuxième étage amplificateur (21B) afin de commander le gain dudit deuxième étage amplificateur.

4. Circuit oscillant selon la revendication 3, où ledit circuit de commande de gain comporte un détecteur (25) permettant de détecter le signal de sortie présent sur la borne de sortie dudit deuxième étage amplificateur et un comparateur (26) permettant de comparer le signal de sortie dudit détecteur (25) avec un signal de référence.

# FIG. 1
## (PRIOR ART)

# FIG. 2

# FIG. 3

# F I G. 4

## F I G. 5

## F I G. 6A

## F I G. 6B

3

F I G. 7